# EUROPEAN PATENT APPLICATION

(11) **EP 1 524 330 A1**
(43) Date of publication of application: **20.04.2005**
(21) Application number: 04256102.7
(22) Date of filing: 01.10.2004
(51) Int. Cl.: C23C 14/34

(54) **Sputter target having modified surface texture**

(30) Priority: 06.10.2003 US 508317; 31.08.2004 US 929505
(71) Applicant: Heraeus, Inc., Chandler, AZ 85044 (US)
(72) Inventor: Kennedy, Steven Roger, Chandler, AZ 85226 (US); Cheng, Yuanda R., Phoenix, AZ 85048 (US); Corno, Philip D., Tempe, AZ 85282 (US); Dary, François, Phoenix, AZ 85044 (US)
(74) Representative: Hill, Justin John

(57) **Abstract**

The effects of sputter re-deposition are reduced by macroscopically roughening the non-sputter areas of the sputter target. The macroscopic roughening is obtained by forming a macroscopic trough pattern in the non-sputter areas of the sputter target. A variety of patterns may be used for the trough pattern. In addition to macroscopically roughing the non-sputter areas of the sputter target, microscopic roughening of the trough patterns may be performed using conventional shot, bead or grit blasting techniques.

## Description

### Field of the Invention

The present invention relates to sputter targets used in physical vapor deposition processes, and more particularly relates to sputter targets having surface textures modified to minimize the effects of sputter re-deposition.

### Background of the Invention

Physical vapor deposition (PVD) techniques, such as sputtering, are used in a variety of fields to provide thin film material deposition of a precisely controlled thickness with an atomically smooth surface. In sputtering processes, a target located in a chamber filled with an inert gas atmosphere is exposed to an electric field to generate a plasma. Ions within this plasma collide with a surface of the sputter target causing the target to emit atoms from the target surface. A voltage difference between the target and the substrate that is to be coated causes the emitted atoms to form the desired film on the surface of the substrate.

Success in sputter coating of thin-film materials, especially sputter coating of thin films in the magnetic data storage industry, however, is highly dependent on the cleanliness of the sputter chamber. At the vacuum levels used in these endeavors, contaminants as small as a gas molecule can significantly alter the course of the small quantities of material transported from a sputter target to the substrate. Further, considering that a magnetic media disk is rejectable if even one small bit of debris is found to disrupt the atomically smooth surface, the purity of the atmosphere within the chamber is paramount.

Sputtering techniques typically form deposits of the target coating material on other surfaces within the chamber in addition to the substrate. Coating material that comes back to coat the non-sputter areas of the sputter target has a high risk of dislodging again due to the energetic nature of the plasma atmosphere. This dislodged debris can contaminate the media surface with large pieces of fatal debris, which then may be coated upon to lock them into the film structure. In light of the stringent cleanliness requirements of the magnetic data storage industry, the effects of sputter re-deposition described above are highly undesired.

Conventional solutions to the problems associated with sputter re-deposition include using shot or bead blasting techniques to microscopically roughen the non-sputter areas of the sputter target. Current blasting techniques for most materials are able to produce standard microscopic surface roughness with values between 120 and 200 micro inches. This roughness increases the surface area on the sputter target and thereby improves the ability to trap any re-deposited material, which provides a cleaner environment in the chamber and a cleaner finished product. However, a need still exists to further mitigate the effects of sputter re-deposition.

### Summary of the Invention

Embodiments of the present invention seek to provide improved sputter targets by modifying the surface texture of the sputter target. Specifically embodiments of the present invention macroscopically roughen the non-sputter areas of the sputter target to improve the ability of the non-sputter areas to trap re-deposited target coating material and reduce the effects of sputter re-deposition in sputtering applications.

According to one aspect of the invention, the non-sputter areas are macroscopically roughened by forming a macroscopic trough pattern in the non-sputter areas. The trough pattern may be formed in any of a number of designs in the non-sputter areas of the sputter target. Furthermore, different non-sputter areas may have different macroscopic trough patterns. The trough patterns are formed in the non-sputter areas using conventional laser ablation methods or machining processes.

According to other aspects of the invention, the macroscopic trough pattern in the non-sputter areas is microscopically roughened using conventional bead or grit blasting techniques. The microscopic roughening further improves the ability to trap re-deposited target coating material and prevent it from contaminating the film applied to the substrate.

In another aspect of the invention, the non-sputter areas are counter-bored into the face of the sputter target in addition to having the macroscopic trough patterns formed in them. Counter-boring the non-sputter areas places them farther away from the plasma environment than the sputter areas and further reduces the chances of re-deposited target coating material dislodging and contaminating the film applied to the substrate.

The foregoing summary of the invention has been provided so that the nature of the invention may be understood quickly. A more complete understanding of the invention can be obtained by reference to the following detailed description, provided by way of example only, and in connection with the accompanying drawings.

### Brief Description of the Drawings

Figure 1 is a diagram depicting the face of a sputter target according to one embodiment of the invention.

Figure 2 is a cross section of a portion of a squared-trough pattern according to one embodiment of the invention.

Figure 3 is a cross section of a portion of an angled-trough pattern according to one embodiment of the invention.

Figure 4 is a cross section of a sputter target according to one embodiment of the invention.

### Detailed Description of the Invention

Embodiments of the present invention concern the modification of the surface texture of sputter targets to minimize the effects associated with sputter re-deposition. Sputter targets are made of a wide variety of materials which depend on the applications in which the sputtering is being used. As one skilled in the art will recognize, the invention described below does not depend on the material of the sputter target and can be applied to sputter targets in general. Accordingly, specific target materials are not mentioned in the description below.

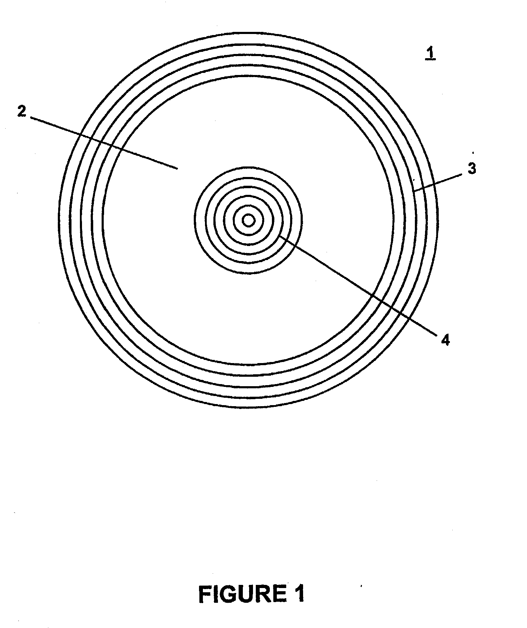

Figure 1 is a diagram depicting the face of a sputter target according to one embodiment of the invention. As shown in Figure 1, the face of sputter target 1 includes sputter area 2, and non-sputter areas 3 and 4. This embodiment of the invention is being described using a circular sputter target having one sputter area surrounding by a non-sputter area in the center of the target and a non-sputter area on the perimeter of the target. The invention is not limited to this configuration, however, and may be used for sputter targets having different shapes, such as rectangular or irregular. In addition, the invention may be used for sputter targets having different numbers and positions of sputter and non-sputter areas, which differ depending on the manufacturer and operator modification of the cathode system being used in the sputtering device.

Sputter area 2 is the area of the sputter target from which the target material is removed for application on the substrate within the sputter chamber. Sputter area 2 is macroscopically smooth, and to a certain degree microscopically smooth as well. For example, in one embodiment of the invention the standard surface roughness of sputter area 2 has values less than 100 micro inches, and preferably less than 65 micro inches.

As described above, the sputtering process tends to deposit target coating material on the non-sputter areas of the sputter target. In order to improve the adhesion properties of the non-sputter areas and reduce the occurrence of this redeposited material being dislodged and contaminating the substrate, embodiments of the present invention macroscopically roughen these areas of the sputter target. Specifically, the embodiments roughen the non-sputter areas of the sputter target by forming a macroscopic trough pattern in these areas.

In Figure 1, the macroscopic trough pattern is depicted in non-sputter areas 3 and 4 as a series of concentric circles. Concentric shapes are not the only trough pattern that can be used. For example, embodiments of the invention may be implemented using other patterns such as spirals or cross-hatching within the non-sputter areas. Furthermore, the trough pattern in each non-sputter area may be different than that used in other non-sputter areas.

To form the macroscopic trough patterns, the surface of the non-sputter areas is macroscopically roughened using either a laser ablation method or a physical machining process. For example, a high-energy YAG or similar laser is used to pattern a precise pattern on the surface of a round, rectangular or irregularly shaped sputter target. Laser powers are set based on the type of laser used, in combination with the sputter target material, with the ultimate goal of controlling the depth and width of the laser-ablated trough forming the trough pattern. Alternatively, the macroscopic trough patterns may be produced using machining tools such as a lathe, mill, or other cutting tool.

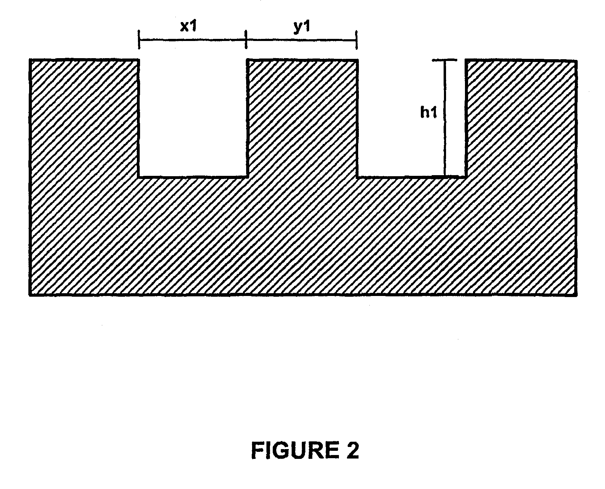

The types of troughs used to form the trough patterns include, but are not limited to, a squared trough and an angled trough. Figure 2 depicts a cross section of a portion of a macroscopic trough pattern formed in non-sputter areas 3 and 4 using a squared trough. The squared troughs depicted in Figure 2 preferably have a width x1 of 0.025 inches, but may be anywhere in the range of 0.020 to 0.050 inches. The squared troughs preferably have a depth h1 of 0.010 inches, but may be anywhere in the range of 0.002 and 0.020 inches. The squared troughs preferably are spaced apart from each other with a spacing yl of 0.025 inches, but may be formed with any spacing greater than 0.005 inches.

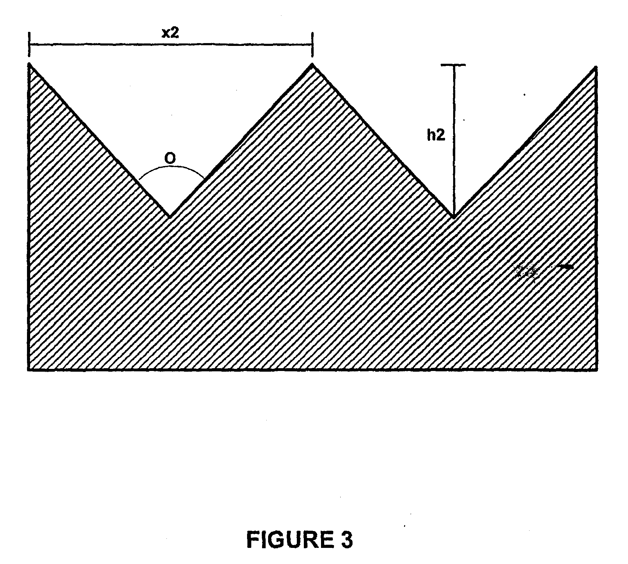

Figure 3 depicts a cross section of a portion of the macroscopic trough pattern formed in non-sputter areas 3 and 4 using an angled trough. The angle troughs depicted in Figure 3 preferably have a width x2 of 0.040 inches, but may be anywhere in the range of 0.030 to 0.050 inches. The angled troughs preferably have a depth h2 of 0.035 inches, but may be anywhere in the range of 0.009 to 0.043 inches. The trough angle θ preferably is 60 degrees, but may be anywhere in the range of 60 to 120 degrees. While the root of the troughs depicted in Figure 3 have a "V" shape, alternative embodiments may use an angled trough having a root with a rounded shape.

Figure 2 and 3 only depict two troughs of the trough pattern formed in non-sputter areas 3 and 4. It is to be understood, however, that the number and troughs used to form the trough patterns in non-sputter areas 3 and 4 will vary depending on the trough pattern, the size of trough used and the size of the non-sputter area.

In an additional embodiment of the invention, microscopic roughening is performed on non-sputter areas 3 and 4 in addition to the macroscopic roughening provided by the trough patterns. Microscopic roughening is typically performed using shot, bead or grit blasting to add microscopic surface roughness, which is not depicted in the figures, to the trough patterns formed in the non-sputter areas. In this manner, the surface area, and thereby the adhesion properties, of non-sputter areas 3 and 4 are further improved.

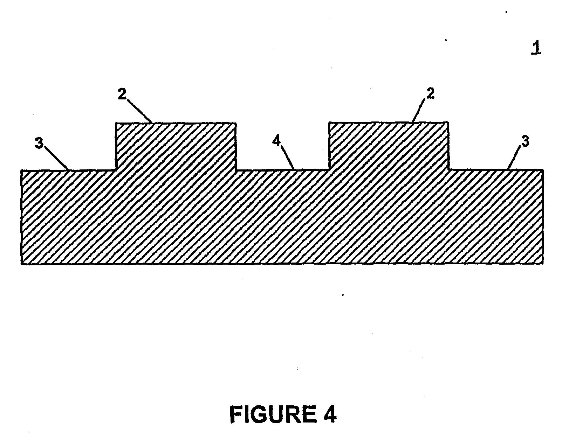

Figure 4 depicts another embodiment of the invention. Specifically, Figure 4 depicts a cross section of sputter target 1 in which non-sputter areas 3 and 4 are counter-bored into the surface of sputter target 1 to place non-sputter areas 3 and 4 at a lower position than sputter area 2 with respect to the plasma environment of the sputter chamber. The counter-bore is performed using physical machining tools such as a lathe, mill or other cutting tools. The cut of the counter-bore forms walls set at 90 degrees to the sputter target face, as depicted in Figure 4. However, the walls may be set at other angles. Preferably, the depth of the cut of the counter-bore is between 0.010 inches from the target top surface down to approximately 0.100 inches from the target bottom surface.

While not depicted in Figure 4, the macroscopic trough patterns discussed above are also formed in the counter-bored non-sputter areas 3 and 4. Furthermore, other embodiments of the invention microscopically roughen non-sputter areas 3 and 4 in addition to being counter-bored and macroscopically roughened with trough patterns. In this manner, the ability of the non-sputter areas to trap re-deposited target coating material is improved and the effects of sputter re-deposition are reduced.

While the foregoing has described what are considered to be the best mode and/or other examples, it is understood that various modifications may be made therein and that the subject matter disclosed herein may be implemented in various forms and examples, and that they may be applied in numerous applications, only some of which have been described herein.

## Claims

1. A sputter target (1) comprising:
a sputter area (2) ; and
a non-sputter area (3, 4) having a macroscopic trough pattern.

2. The sputter target (1) according to Claim 1, further comprising a plurality of non-sputter areas (3, 4), wherein each of the non-sputter areas has a macroscopic trough pattern.

3. The sputter target (1) according to Claim 2, wherein one of the plurality of non-sputter areas is a center area (4) of the sputter target.

4. The sputter target (1) according to Claim 2 or 3, wherein one of the plurality of non-sputter areas is a perimeter area (3) of the sputter target.

5. The sputter target (1) according to any preceding claim, wherein the macroscopic trough pattern comprises a plurality of troughs forming a series of concentric shapes.

6. The sputter target (1) according to any of claims 1-4, wherein the macroscopic trough pattern comprises a trough forming a spiral pattern.

7. The sputter target (1) according to any preceding claim, wherein the macroscopic trough pattern is a squared-trough pattern.

8. The sputter target (1) according to any preceding claim, wherein the non-sputter area is counter-bored in the surface of the sputter target.

9. The sputter target (1) according to any of claims 1-6, wherein the macroscopic trough pattern is an angled-trough pattern.

10. The sputter target (1) according to any preceding claim, wherein a non-sputter area is microscopically roughened.

11. A method for preparing a sputter target (1) comprising the step of etching a macroscopic trough pattern in a non-sputter area (3, 4).

12. The method according to Claim 11, further comprising the step of etching a macroscopic trough pattern in a plurality of non-sputter areas (3, 4).

13. The method according to Claim 11 or 12, wherein the macroscopic trough pattern comprises a plurality of troughs forming a series of concentric shapes.

14. The method according to Claim 11 or 12, wherein the macroscopic trough pattern comprises a trough forming a spiral pattern.

15. The method according to any of claims 11-14, wherein the macroscopic trough pattern is a squared-trough pattern.

16. The method according to any of claims 11-14, wherein the macroscopic trough pattern is an angled-trough pattern.

17. The method according to any of claims 11-16" wherein the macroscopic trough pattern is etched in a non-sputter area (3, 4) using a machining process.

18. The method according to any of claims 11-16, wherein the macroscopic trough pattern is etched in a non-sputter area (3, 4) using a laser ablation process.

19. The method according to any of claims 11-16, further comprising the step of blasting the macroscopic trough pattern in a non-sputter area (3, 4) with microscopic particulate.

20. The method according to any of claims 11-16, further comprising the step of counter-boring a non-sputter area (3, 4) in the surface of the sputter target (1).
